# EUROPEAN PATENT APPLICATION

(11) **EP 4 841 281 A1**
(43) Date of publication of application: **18.11.2026**
(21) Application number: 25901719.2
(22) Date of filing: 25.11.2025
(51) Int. Cl.: G01R 31/3835, G01R 31/392, G01R 31/36, G01R 19/12, H02J 7/00

(54) **SECONDARY BATTERY LOW VOLTAGE DEFECT INSPECTION METHOD**

(30) Priority: 05.12.2024 KR 20240179198
(71) Applicant: LG Energy Solution, Ltd., Seoul 07335 (KR)
(72) Inventor: PYUN, Kyu Ho, Daejeon 34122 (KR); KIM, Min Hong, Daejeon 34122 (KR)
(74) Representative: Goddar, Heinz J.
(86) International application number: PCT/KR2025/019701
(87) International publication number: WO 2026/121681

(57) **Abstract**

According to exemplary embodiments, a defect inspection method of a secondary battery is provided. The method may include a first charging step of charging a secondary battery to a first SOC (State of Charge) at a first C-rate; a second charging step of charging the secondary battery to a second SOC at a second C-rate of 0.003 C or less after the first charging step; and a detection step of determining a defect of the secondary battery after the second charging step. The second C-rate may be smaller than the first C-rate. The second SOC may be greater than the first SOC.

## Description

### [Technical Field]

The present disclosure relates to a low voltage defect inspection method of a secondary battery. This application claims the benefit of priority from Korean Patent Application No. 10-2024-0179198, filed on December 5, 2024, the entire contents disclosed therein are incorporated by reference into this disclosure.

### [Background]

Unlike primary batteries, secondary batteries can be charged and discharged multiple times. Secondary batteries are widely used as energy sources for various wireless devices such as handsets, laptops, wireless vacuum cleaners, etc. Recently, due to energy density improvements and economies of scale, the manufacturing cost per unit capacity of secondary batteries has dramatically decreased, and as the cruising distance of BEVs (battery electric vehicles) has increased to a level equivalent to fuel vehicles, the primary applications of secondary batteries are shifting from mobile devices to mobility.

The manufacture of the secondary battery includes an electrode process including mixing, coating, roll pressing, slitting, and notching processes; an assembly process of embedding an electrode assembly in a case; and an activation process of electrically activating and stabilizing the secondary battery. After the activation process, the secondary battery may be stacked to form a cell stack. The cell stack may be mounted in a housing together with a module frame, or may be directly mounted in the housing without the module frame.

In the secondary battery, various types of defects may occur due to various causes during the manufacturing process or use. In particular, some of the secondary batteries for which manufacture has been completed exhibit a phenomenon showing a voltage drop behavior exceeding a self-discharge rate, and this phenomenon is referred to as low voltage.

The low voltage defect phenomenon of the secondary battery is typically caused by metallic foreign matter located inside in many cases. In particular, when metallic foreign matter such as iron or copper exists on a positive electrode plate of the secondary battery, the metallic foreign matter may grow into a dendrite at a negative electrode. In addition, such a dendrite may cause an internal short circuit of the secondary battery, which may lead to failure or damage of the secondary battery, or in severe cases, ignition.

Although some technologies for inspecting the low voltage defect of the secondary battery have been proposed so far, there is a limit in effectively and rapidly detecting the low voltage defect of the secondary battery.

### [Summary]

### [Technical Problem]

A problem to be solved by the technical idea of the present disclosure is to provide a defect inspection method of a secondary battery in which a defect detection time is shortened and inspection accuracy is improved.

### [Technical Solution]

According to exemplary embodiments of the present disclosure for solving the above-described problem, a defect inspection method of a secondary battery is provided. The method may include a first charging step of charging a secondary battery to a first SOC (State of Charge) at a first C-rate; a second charging step of charging the secondary battery to a second SOC at a second C-rate of 0.003 C or less after the first charging step; and a detection step of determining a defect of the secondary battery after the second charging step. The second C-rate may be smaller than the first C-rate. The second SOC may be greater than the first SOC.

The second charging step may be performed for 5 minutes to 30 minutes.

The detection step may determine whether the secondary battery is defective based on a voltage change amount of the secondary battery during the second charging step.

The detection step may determine whether the secondary battery is defective based on a slope of voltage over time of the secondary battery during the second charging step.

The detection step may determine whether the secondary battery is defective based on voltage change amounts measured for each of a plurality of time intervals during the second charging step.

The method may include, before the first charging step, a first aging step of aging the secondary battery; a formation step of charging the secondary battery after the first aging step; a second aging step of aging the secondary battery after the formation step; a full charge step of fully charging the secondary battery after the second aging step; and a full discharge step of fully discharging the secondary battery after the full charge step.

The second SOC may be SOC 30% or less.

The second C-rate may be 4×10⁻¹⁰ C or more.

The first C-rate may be 0.1 C or more and 2.0 C or less.

Each of the first SOC and the second SOC may be selected from an SOC section in which a second derivative (d²V/dSOC²) of voltage-SOC is within a reference range in a voltage-SOC profile during a charging process of a normal battery.

The voltage-SOC profile of the normal battery may include a section in which a second derivative (d²V/dSOC²) of voltage-SOC is 0 between the first SOC and the second SOC.

Each of the first SOC and the second SOC may be selected from an SOC section in which a second derivative (d²V/dSOC²) of voltage-SOC is within a reference range in a voltage-SOC profile during a discharge process of a normal battery.

The voltage-SOC profile of the normal battery may include a section in which a second derivative (d²V/dSOC²) of voltage-SOC is 0 between the first SOC and the second SOC.

The second SOC may be greater than the first SOC by SOC 1% to SOC 5%.

The method may further include, between the first charging step and the second charging step, a stabilization step of the secondary battery.

### [Advantageous Effects]

According to exemplary embodiments of the present disclosure, a secondary battery can be charged at a low rate in an SOC section where a voltage change rate is relatively constant, and a low voltage defect of the secondary battery can be detected based on a voltage change of the secondary battery during the low-rate charge. Accordingly, the speed and accuracy of the low voltage defect inspection method of a secondary battery can be improved.

The effects that can be obtained in exemplary embodiments of the present disclosure are not limited to the above-described effects, and other effects not mentioned can be clearly understood by a person skilled in the art from the description of the disclosure described below. In other words, unintended effects of implementing the exemplary embodiments of the present disclosure may also be derived from the exemplary embodiments of the present disclosure by a person skilled in the art.

### [Brief Description of the Drawings]

FIG. 1 is a flowchart for explaining a defect inspection method of a secondary battery according to exemplary embodiments.
FIG. 2 is a flowchart for explaining an activation process of a secondary battery according to exemplary embodiments.
FIG. 3 is a cross-sectional view showing a secondary battery according to exemplary embodiments.
FIG. 4 is a graph showing an average value of voltage over time of normal batteries and an average value of voltage over time of defective batteries.
FIG. 5 is a graph showing a voltage change amount over time of each of normal batteries and each of defective batteries.
FIG. 6 is a graph showing an average value of a voltage change amount over time of normal batteries and an average value of a voltage change amount over time of defective batteries.

### [Detailed Description]

Hereinafter, preferred embodiments of the present disclosure will be described in detail with reference to the accompanying drawings. Prior to this, the terms or words used in the present specification and claims should not be construed as being limited to conventional or dictionary meanings, and should be interpreted as meanings and concepts that conform to the technical idea of the present disclosure based on the principle that the inventors can appropriately define the concept of terms in order to describe their own invention in the best way.

Therefore, it should be understood that the embodiments described in the present specification and the configurations shown in the drawings are merely one most preferred embodiment of the present disclosure and do not represent all of the technical ideas of the present disclosure, so that various equivalents and modifications that may replace them may exist at the time of filing the present application.

In addition, in describing the present disclosure, when it is determined that a detailed description of a related known configuration or function may obscure the gist of the present disclosure, the detailed description thereof will be omitted.

The embodiments of the present disclosure are provided to more completely describe the present disclosure to those skilled in the art, so the shapes and sizes of components in the drawings may be exaggerated, omitted, or schematically illustrated for clearer explanation. Therefore, the size or ratio of each component does not entirely reflect the actual size or ratio.

### (First and Second Embodiments)

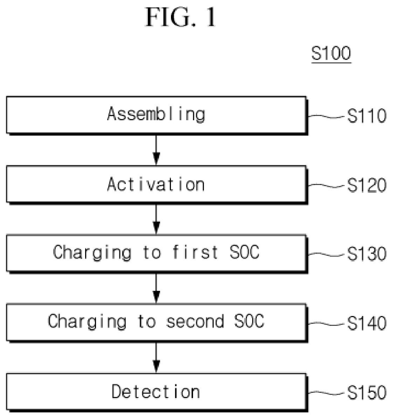

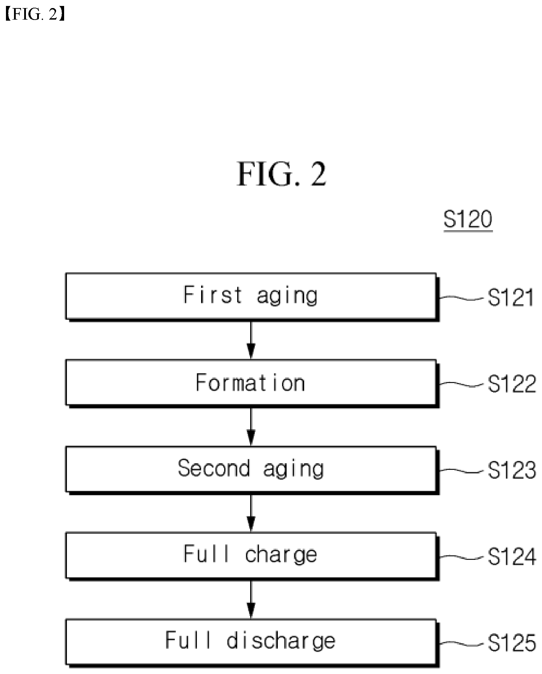

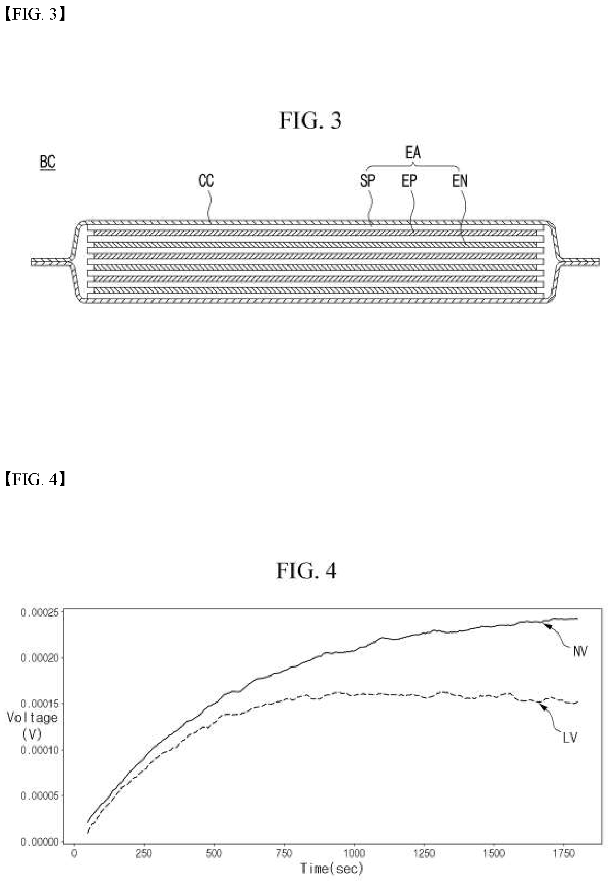

FIG. 1 is a flowchart for explaining a defect inspection method (S100) of a secondary battery according to exemplary embodiments. FIG. 2 is a flowchart for showing an activation method (S120) of a secondary battery according to exemplary embodiments. FIG. 3 is a cross-sectional view showing a secondary battery (BC) according to exemplary embodiments.

Referring to FIG. 1, the defect inspection method (S100) of a secondary battery according to the present disclosure may include an assembling step (S110), an activation step (S120), a step of charging to a first SOC (S130), a step of charging to a second SOC (S140), and a detection step (S150).

Referring to FIG. 2, the activation step (S120) may include a first aging step (S121), a formation step (S122), a second aging step (S123), a full charge step (S124), and a full discharge step (S125).

Referring to FIG. 1 to FIG. 3 together, the defect inspection method (S100) of a secondary battery may include a step (S110) of assembling a secondary battery (BC).

The secondary battery (BC) may include a battery case (CC) and an electrode assembly (EA). The secondary battery (BC) may further include an electrolyte solution injected into the battery case (CC).

Hereinafter, the technical idea of the present disclosure will be described focusing on an example in which the electrode assembly (EA) includes a plurality of positive electrodes (EP), a plurality of negative electrodes (EN), and a plurality of separators (SP) that are stacked. A person having ordinary skill in the art can easily arrive at an embodiment in which the electrode assembly includes a wound structure of a positive electrode, a negative electrode, and a separator interposed therebetween, based on what is described herein.

Each of the plurality of positive electrodes (EP) may include a positive electrode current collector and a positive electrode active material. The thickness of the positive electrode current collector may range from about 3 µm to about 500 µm. The positive electrode current collector may not cause a chemical change in the finally manufactured secondary battery and may have high conductivity. The positive electrode current collector may include, for example, any one of stainless steel, nickel, titanium, calcined carbon, and aluminum. The positive electrode current collector may include stainless steel surface-treated by carbon, nickel, titanium, silver, or the like. The surface of the positive electrode current collector may include a fine irregular structure for increasing adhesion of an active material. The shape of the positive electrode current collector may include any one of a film, a sheet, a foil, a net, a porous body, a foam, and a nonwoven fabric.

The positive electrode active material is a material capable of causing an electrochemical reaction. The positive electrode active material may be a lithium transition metal oxide. The positive electrode active material may include, for example, any one of olivine-based lithium metal phosphates represented by the formula Li₁₊ₓM_{1-y}M'_{y}PO_{4-z}X_{z} (where M is a transition metal, more specifically any one of Fe, Mn, Co, and Ni, M' is any one of Al, Mg, and Ti, X is any one of F, S, and N, -0.5≤x≤+0.5, 0≤y≤0.5, and 0≤z≤0.1). The positive electrode active material may include, for example, lithium iron phosphate. The positive electrode active material may further include a lithium metal oxide represented by the formula Li₁₊ₓM_{1-y}M'_{y}O_{2-z}X_{z} (where M is a main metal that is one of Fe, Mn, Co, and Ni, M' is a substitution metal element that is one different from M among Fe, Mn, Co, and Ni, and X is a substitutable nonmetal element or defect). The positive electrode active material may include, for example, lithium iron oxide.

Each of the plurality of negative electrodes (EN) may include a negative electrode current collector and a negative electrode active material. The thickness of the negative electrode current collector may range from about 3 µm to about 500 µm. The negative electrode current collector may not cause a chemical change in the finally manufactured secondary battery and may have high conductivity. The negative electrode current collector may include any one of copper, stainless steel, aluminum, nickel, titanium, calcined carbon, and aluminum-cadmium alloy. The negative electrode current collector may include stainless steel surface-treated by carbon, nickel, titanium, silver, or the like. The surface of the negative electrode current collector may include a fine irregular structure for increasing adhesion of an active material. The shape of the negative electrode current collector may include any one of a film, a sheet, a foil, a net, a porous body, a foam, and a nonwoven fabric.

The negative electrode active material may include, for example, carbon such as non-graphitizable carbon and graphite-based carbon. The negative electrode active material may include, for example, metal composite oxides such as LiₓFe₂O₃ (0≤x≤1), LiₓWO₂ (0≤x≤1), SnₓMe₁₋ₓMe'_{y}O_{z} (where Me is any one of Mn, Fe, Pb, and Ge, Me' is any one of Al, B, P, Si, group 1, group 2, group 3 elements of the periodic table, and halogens; 0<x≤1; 1≤y≤3; and 1≤z≤8). The negative electrode active material may include, for example, any one of lithium metal; lithium alloy; silicon-based alloy; and tin-based alloy. The negative electrode active material may include, for example, metal oxides such as SnO, SnO₂, PbO, PbO₂, Pb₂O₃, Pb₃O₄, Sb₂O₃, Sb₂O₄, Sb₂O₅, GeO, GeO₂, Bi₂O₃, Bi₂O₄, and Bi₂O₅. The negative electrode active material may also include, for example, conductive polymers such as polyacetylene; Li-Co-Ni based materials, or the like.

The plurality of positive electrodes (EP) and the plurality of negative electrodes (EN) may alternate with the separators (SP). Accordingly, one of the plurality of positive electrodes (EP) and the plurality of negative electrodes (EN) may be interposed between two adjacent ones of the separators (SP). Each of the separators (SP) may be in contact with at least one of the plurality of positive electrodes (EP) and the plurality of negative electrodes (EN). Each of the separators (SP) may isolate the plurality of positive electrodes (EP) and the plurality of negative electrodes (EN) by preventing direct contact between the plurality of positive electrodes (EP) and the plurality of negative electrodes (EN). Accordingly, a short circuit between the plurality of positive electrodes (EP) and the plurality of negative electrodes (EN) may be prevented. Each of the plurality of positive electrodes (EP) and the plurality of negative electrodes (EN) may have a flat film shape.

The battery case (CC) may include a cup-shaped accommodating portion. The accommodating portion may be formed by a pouch forming process. The electrode assembly (EA) may be accommodated in the accommodating portion. The battery case (CC) may be any one of a pouch case, a cylindrical can, and a prismatic can. The electrode assembly (EA) may be embedded in the battery case (CC). Hereinafter, the technical idea of the present disclosure will be described based on an example in which the battery case (CC) is an aluminum laminate sheet, but a person having ordinary skill in the art can easily arrive at an example in which the battery case (CC) is one of a cylindrical can and a prismatic can, based on what is described herein.

The battery case (CC) may include an inner resin layer, a metal layer, and an outer resin layer. An adhesive and a corrosion prevention layer may be further provided between the inner resin layer and the metal layer and between the outer resin layer and the metal layer.

The inner resin layer may have thermal adhesiveness and may be referred to as a sealant layer. The inner resin layer enables sealing of the battery case (CC). The inner resin layer may include, for example, polyolefin-based resin such as polypropylene (PP) and polyethylene (PE). The metal layer may include one of an alloy of iron, carbon, chromium, and manganese, an alloy of iron, chromium, and nickel, and aluminum. The metal layer may be a gas barrier. The metal layer may block entry and exit of gas from the battery case (CC). The outer resin layer may be a surface protective layer. The outer resin layer may include a material having abrasion resistance and heat resistance, such as nylon resin.

The electrolyte solution may be any one of a non-aqueous electrolyte solution, an aqueous electrolyte solution, an ionic electrolyte solution, and a gel electrolyte. The electrolyte solution may be a solid electrolyte. The non-aqueous electrolyte solution may include an organic solvent such as ethylene carbonate and dimethyl carbonate, and a lithium salt such as LiPF₆ and LiBF₄ dissolved in the organic solvent. The non-aqueous electrolyte solution may also include ethylene carbonate dissolved in tetraethylammonium salts. The aqueous electrolyte solution may include a sodium chloride solution, a sulfuric acid solution, a hydrochloric acid solution, and a sodium hydroxide solution. The ionic electrolyte solution is, for example, an ionic compound that is in a liquid state at room temperature, such as ethylmethylimidazolium bis(trifluoromethylsulfonyl)amide, and has high thermal stability. The gel electrolyte may be provided by using a liquid electrolyte solution with polyacrylonitrile, PVA, or the like. The solid electrolyte may also include a ceramic electrolyte composed of a polymer material doped with a lithium salt (e.g., polyethylene oxide (PEO)) and a ceramic material such as NASICON and LLZO.

The defect inspection method (S100) of a secondary battery may include a step (S120) of activating the secondary battery (BC). The activation step (S120) may include a first aging step (S121), a formation step (S122), a second aging step (S123), a full charge step (S124), and a full discharge step (S125).

The first aging step (S121) may be a step of aging the secondary battery (BC) assembled in the assembling step (S110) for a predetermined time. According to exemplary embodiments, in the first aging step (S121), the secondary battery (BC) may be stored in a chamber in which a predetermined temperature condition is constantly maintained for a predetermined time.

According to exemplary embodiments, in the first aging step (S121), the secondary battery (BC) may be stored under a temperature condition of about 10°C or higher. According to exemplary embodiments, in the first aging step (S121), the secondary battery (BC) may be stored under a temperature condition of about 20°C or higher. According to exemplary embodiments, in the first aging step (S121), the secondary battery (BC) may be stored under a temperature condition of about 40°C or lower. According to exemplary embodiments, in the first aging step (S121), the secondary battery (BC) may be stored under a temperature condition of about 30°C or lower.

According to exemplary embodiments, the first aging step (S121) may be performed for about 24 hours or more. According to exemplary embodiments, the first aging step (S121) may be performed for about 36 hours or more. According to exemplary embodiments, the first aging step (S121) may be performed for about 72 hours or less. According to exemplary embodiments, the first aging step (S121) may be performed for about 48 hours or less. For example, the first aging step (S121) may be configured to be performed for about 30 hours under a temperature condition of about 20°C.

The first aging step (S121) may be performed immediately after the assembling step (S110) of the secondary battery (BC). That is, in a state in which the electrode assembly (EA) and the electrolyte solution are accommodated inside the battery case (CC) and the battery case (CC) is sealed, the first aging step (S121) may be performed immediately without performing other processes.

The first aging step (S121) may allow the electrolyte solution injected into the secondary battery (BC) in the assembling step (S110) to be uniformly mixed. The first aging step (S121) may allow the electrolyte solution injected into the secondary battery (BC) in the assembling step (S110) to spread uniformly inside the secondary battery (BC). The first aging step (S121) may facilitate ion exchange between the plurality of positive electrodes (EP) and the plurality of negative electrodes (EN) by allowing electrolyte solution impregnation to be uniformly performed on the plurality of separators (SP).

In the formation step (S122), the secondary battery (BC) that has been aged in the first aging step (S121) may be charged to a predetermined SOC (State of Charge). According to exemplary embodiments, the formation step (S122) may be configured to charge the secondary battery (BC) to about SOC 30% or more. According to exemplary embodiments, the formation step (S122) may be configured to charge the secondary battery (BC) to about SOC 40% or more. According to exemplary embodiments, the formation step (S122) may be configured to charge the secondary battery (BC) to about SOC 50% or more. According to exemplary embodiments, the formation step (S122) may be configured to charge the secondary battery (BC) to about SOC 70% or less. According to exemplary embodiments, the formation step (S122) may be configured to charge the secondary battery (BC) to about SOC 60% or less. According to exemplary embodiments, the formation step (S122) may be configured to charge the secondary battery (BC) to about SOC 50% or less.

In the formation step (S122), the secondary battery (BC) that has been aged in the first aging step (S121) may be charged for a predetermined time. According to exemplary embodiments, the formation step (S122) may be performed for 70 minutes or more. According to exemplary embodiments, the formation step (S122) may be performed for 80 minutes or more. According to exemplary embodiments, the formation step (S122) may be performed for 90 minutes or more. According to exemplary embodiments, the formation step (S122) may be performed for 180 minutes or less. According to exemplary embodiments, the formation step (S122) may be performed for 170 minutes or less. According to exemplary embodiments, the formation step (S122) may be performed for 160 minutes or less.

The formation step (S122) may be performed at a predetermined C-rate. According to exemplary embodiments, in the formation step (S122), the secondary battery (BC) may be charged at a C-rate of about 0.1 C or more. According to exemplary embodiments, in the formation step (S122), the secondary battery (BC) may be charged at a C-rate of about 0.2 C or more. According to exemplary embodiments, in the formation step (S122), the secondary battery (BC) may be charged at a C-rate of about 0.5 C or more. According to exemplary embodiments, in the formation step (S122), the secondary battery (BC) may be charged at a C-rate of about 2.0 C or less. According to exemplary embodiments, in the formation step (S122), the secondary battery (BC) may be charged at a C-rate of about 1.0 C or less. According to exemplary embodiments, in the formation step (S122), the secondary battery (BC) may be charged at a C-rate of about 0.5 C or less.

The formation step (S122) may be performed at a predetermined temperature. According to exemplary embodiments, the formation step (S122) may be performed under a temperature condition of about 10°C or higher. According to exemplary embodiments, the formation step (S122) may be performed under a temperature condition of about 20°C or higher. According to exemplary embodiments, the formation step (S122) may be performed under a temperature condition of about 40°C or lower. According to exemplary embodiments, the formation step (S122) may be performed under a temperature condition of about 30°C or lower. For example, the formation step (S122) may be configured to charge the secondary battery to about SOC 50% at a C-rate of about 0.2 C at a temperature of about 25°C.

By performing the formation step (S122) under the above-described conditions of SOC, time, C-rate, and temperature, a SEI (Solid Electrolyte Interphase) layer of the secondary battery (BC) may be uniformly formed with an appropriate thickness. The formation step (S122) may charge the secondary battery (BC) with a charging voltage of about 3.4 V to about 3.7 V. However, such a charging voltage may vary depending on the type or characteristics of the secondary battery (BC).

In the second aging step (S123), the secondary battery (BC) charged in the formation step (S122) may be aged at a predetermined temperature for a predetermined time.

According to exemplary embodiments, in the second aging step (S123), the secondary battery (BC) may be stored under a temperature condition of about 60°C to about 70°C. According to exemplary embodiments, in the second aging step (S123), the secondary battery (BC) may be stored for about 12 hours to about 72 hours. In the second aging step (S123), additional wetting may proceed in a portion of the electrode assembly (EA) where the electrolyte solution has not sufficiently penetrated. Stabilization of the SEI layer may also proceed in the second aging step (S123). In addition, when metallic foreign matter or the like that may cause a low voltage defect of the secondary battery (BC) is present inside the secondary battery (BC), additional growth of the metallic foreign matter may occur in the second aging step (S123).

In the full charge step (S124), the secondary battery (BC) may be charged until the SOC reaches about 100%. According to exemplary embodiments, in the full charge step (S124), the secondary battery (BC) may be charged at a C-rate of about 0.1 C to about 2.0 C. According to exemplary embodiments, in the full charge step (S124), the secondary battery (BC) may be charged under a temperature condition of about 20°C to about 45°C.

In the full discharge step (S125), the fully charged secondary battery (BC) may be discharged until the SOC reaches about 0%. According to exemplary embodiments, the full discharge step (S125) may discharge the secondary battery (BC) at a C-rate of about 0.1 C to about 2.0 C. According to exemplary embodiments, the full discharge step (S125) may discharge the secondary battery (BC) under a temperature condition of about 20°C to about 45°C.

The full charge step (S124) and the full discharge step (S125) may stabilize the SEI layer. In addition, the full charge step (S124) and the full discharge step (S125) may additionally grow metallic foreign matter inside the secondary battery (BC), thereby improving the low voltage defect detection accuracy in the detection step (S150) to be described later. According to exemplary embodiments, the full charge step (S124) and the full discharge step (S125) may each be performed multiple times.

The method (S100) of manufacturing a secondary battery may include a step (S130) of charging the secondary battery (BC) to a first SOC and a step (S140) of charging the secondary battery (BC) to a second SOC.

Each of the first SOC in the charging step (S130) and the second SOC in the charging step (S140) may be determined based on a voltage profile according to SOC during a charging process of a normal secondary battery (hereinafter, voltage-SOC charging profile). The first SOC and the second SOC may be selected from a section in which a voltage change rate is relatively constant in the voltage-SOC charging profile of a normal secondary battery. According to exemplary embodiments, the first SOC and the second SOC may be selected from an SOC section in which a second derivative (d²V/dSOC²) of voltage-SOC is within a reference range in the voltage-SOC charging profile of a normal secondary battery. According to exemplary embodiments, the first SOC and the second SOC may be selected from an SOC section in which a second derivative (d²V/dSOC²) of voltage-SOC is substantially 0 in the voltage-SOC charging profile of a normal secondary battery. According to exemplary embodiments, the voltage-SOC charging profile of the normal battery may include at least a portion of a section in which a second derivative (d²V/dSOC²) of voltage-SOC is substantially 0 between the first SOC and the second SOC.

Alternatively, each of the first SOC in the charging step (S130) and the second SOC in the charging step (S140) may be determined based on a voltage profile according to SOC during a discharge process of a normal secondary battery (hereinafter, voltage-SOC discharge profile). The first SOC and the second SOC may be selected from a section in which a voltage change rate is relatively constant in the voltage-SOC discharge profile of a normal secondary battery. According to exemplary embodiments, the first SOC and the second SOC may be selected from an SOC section in which a second derivative (d²V/dSOC²) of voltage-SOC is within a reference range in the voltage-SOC discharge profile of a normal secondary battery. According to exemplary embodiments, the first SOC and the second SOC may be selected from an SOC section in which a second derivative (d²V/dSOC²) of voltage-SOC is substantially 0 in the voltage-SOC discharge profile of a normal secondary battery. According to exemplary embodiments, the voltage-SOC discharge profile of the normal battery may include at least a portion of a section in which a second derivative (d²V/dSOC²) of voltage-SOC is substantially 0 between the first SOC and the second SOC.

That is, the first SOC and the second SOC may be determined within a section in which a voltage change rate according to SOC is relatively constant in the charging profile or the discharge profile of a normal secondary battery. Accordingly, the charging step (S140) may proceed in an SOC section in which the voltage change rate according to SOC is relatively constant. Since voltage fluctuation due to factors other than a low voltage defect is relatively small in a section in which the voltage change rate according to SOC is relatively constant, a difference between a voltage of a normal secondary battery and a voltage of a secondary battery with a low voltage defect in the charging step (S140) can be precisely detected.

In contrast, when an SOC section in which the variation width of the voltage change rate according to SOC is large in the charging profile or the discharge profile of a normal secondary battery is selected, voltage fluctuation due to factors other than a low voltage defect is also reflected in the charging step (S140), so the accuracy of defect detection due to low voltage may be deteriorated.

According to exemplary embodiments, the method (S100) of manufacturing a secondary battery may further include a stabilization step of the secondary battery (BC) between the charging step (S130) and the charging step (S140). During the stabilization step, power supply to the secondary battery (BC) may be stopped, and the secondary battery (BC) may be stabilized. According to exemplary embodiments, the stabilization step may be performed for about 8 hours to about 24 hours. According to exemplary embodiments, the stabilization step may be performed under a temperature condition of about 25°C to about 40°C.

The second SOC in the charging step (S130) may be greater than the first SOC in the charging step (S140). According to exemplary embodiments, a difference between the first SOC and the second SOC may be about SOC 1% or more. According to exemplary embodiments, the difference between the first SOC and the second SOC may be about SOC 2% or more. According to exemplary embodiments, the difference between the first SOC and the second SOC may be about SOC 4% or more. According to exemplary embodiments, the difference between the first SOC and the second SOC may be about SOC 10% or less. According to exemplary embodiments, the difference between the first SOC and the second SOC may be about SOC 6% or less. According to exemplary embodiments, the difference between the first SOC and the second SOC may be about SOC 5% or less.

According to exemplary embodiments, the first SOC may be about 5% or more. According to exemplary embodiments, the first SOC may be about 10% or more. According to exemplary embodiments, the first SOC may be about 20% or more. According to exemplary embodiments, the first SOC may be about 100% or less. According to exemplary embodiments, the first SOC may be about 50% or less. According to exemplary embodiments, the first SOC may be about 30% or less.

According to exemplary embodiments, the second SOC may be about 5% or more. According to exemplary embodiments, the second SOC may be about 10% or more. According to exemplary embodiments, the second SOC may be about 20% or more. According to exemplary embodiments, the second SOC may be about 100% or less. According to exemplary embodiments, the second SOC may be about 50% or less. According to exemplary embodiments, the second SOC may be about 30% or less.

In the charging step (S130), the secondary battery (BC) may be charged at a first C-rate. In the charging step (S140), the secondary battery (BC) may be charged at a second C-rate. The second C-rate may be smaller than the first C-rate.

According to exemplary embodiments, the first C-rate may be about 0.1 C or more. According to exemplary embodiments, the first C-rate may be about 0.2 C or more. According to exemplary embodiments, the first C-rate may be about 0.5 C or more. According to exemplary embodiments, the first C-rate may be about 1.0 C or more. According to exemplary embodiments, the first C-rate may be about 3.0 C or less. According to exemplary embodiments, the first C-rate may be about 2.0 C or less. According to exemplary embodiments, the first C-rate may be about 1.0 C or less. According to exemplary embodiments, the first C-rate may be about 0.5 C or less.

According to exemplary embodiments, the second C-rate may be about 4×10⁻¹⁰ C or more. According to exemplary embodiments, the second C-rate may be about 1×10⁻⁹ C or more. According to exemplary embodiments, the second C-rate may be about 1×10⁻⁸ C or more. According to exemplary embodiments, the second C-rate may be about 0.003 C or less. According to exemplary embodiments, the second C-rate may be about 0.001 C or less. According to exemplary embodiments, the second C-rate may be about 0.0001 C or less.

In the charging step (S140), the secondary battery (BC) is charged at the above-described low second C-rate, so that voltage fluctuation due to overpotential or resistance loss can be minimized. That is, the voltage of the secondary battery (BC) measured in the charging step (S140) may be close to the Open Circuit Voltage (OCV) reflecting the equilibrium state of the chemical reaction inside the secondary battery (BC). Therefore, in the subsequent detection step (S150), a low voltage defect due to an internal defect or the like of the secondary battery (BC) can be detected based on the voltage change amount of the secondary battery (BC) in the charging step (S140).

The charging step (S140) may be performed for a predetermined time. According to exemplary embodiments, the charging step (S140) may be performed for about 3 minutes or more. According to exemplary embodiments, the charging step (S140) may be performed for about 5 minutes or more. According to exemplary embodiments, the charging step (S140) may be performed for about 10 minutes or more. According to exemplary embodiments, the charging step (S140) may be performed for about 15 minutes or more. According to exemplary embodiments, the charging step (S140) may be performed for about 60 minutes or less. According to exemplary embodiments, the charging step (S140) may be performed for about 50 minutes or less. According to exemplary embodiments, the charging step (S140) may be performed for about 40 minutes or less. According to exemplary embodiments, the charging step (S140) may be performed for about 30 minutes or less.

The defect inspection method (S100) of a secondary battery according to exemplary embodiments of the present disclosure can charge the secondary battery (BC) at a low C-rate in a section where the voltage change rate is relatively constant, and can detect a low voltage defect of the secondary battery (BC) based on the voltage change of the secondary battery (BC) due to charging. Unlike the conventional inspection method in which the secondary battery (BC) was aged for several days (for example, 2 days to 7 days) to observe the voltage change of the secondary battery (BC), the defect inspection method (S100) of a secondary battery according to the present disclosure has a significantly reduced inspection time, thereby improving the efficiency of the inspection process, and the precision and reliability of the inspection are improved.

The method (S100) of manufacturing a secondary battery may include a detection step (S150) of detecting a low voltage defect of the secondary battery (BC).

The detection step (S150) may determine whether the secondary battery (BC) has a low voltage defect based on voltage data over time of the secondary battery (BC) recorded in the charging step (S140).

According to exemplary embodiments, the detection step (S150) may determine whether the secondary battery (BC) is defective based on a voltage change amount of the secondary battery (BC) during the charging step (S140). When a voltage change amount of the secondary battery (BC) under inspection matches a voltage change amount of a normal secondary battery within a tolerance range, the secondary battery (BC) under inspection may be determined to be normal. On the other hand, when a voltage change amount of the secondary battery (BC) under inspection deviates from a tolerance range from a voltage change amount of a normal secondary battery, the secondary battery (BC) under inspection may be determined to be defective. According to other exemplary embodiments, the detection step (S150) may also determine whether the secondary battery (BC) is defective based on a voltage change amount of the secondary battery (BC) measured for each time interval by dividing the charging step (S140) into a plurality of time intervals.

According to other exemplary embodiments, the detection step (S150) may determine whether the secondary battery (BC) is defective based on a slope of voltage over time of the secondary battery (BC) during the charging step (S140). When a slope of voltage over time of the secondary battery (BC) under inspection matches a slope of voltage over time of a normal secondary battery within a tolerance range, the secondary battery (BC) under inspection may be determined to be normal. On the other hand, when a slope of voltage over time of the secondary battery (BC) under inspection deviates from a tolerance range from a slope of voltage over time of a normal secondary battery, the secondary battery (BC) under inspection may be determined to be defective.

FIG. 4 to FIG. 6 are embodiments for helping understanding of the present disclosure. The embodiments according to the present disclosure may be modified in various different forms, and the scope of the present disclosure is not limited thereto. The embodiments of the present disclosure are provided to explain the present disclosure to a person having ordinary skill in the art.

FIG. 4 to FIG. 6 are graphs showing voltage change amounts in the charging step (S140) of eight normal batteries (NV) and eight defective batteries (LV). For each of the normal batteries (NV) and each of the defective batteries (LV), before the charging step (S140), the activation step (S120) and the charging step (S130) of FIG. 1 were performed under the same conditions.

FIG. 4 shows an average value of voltage of the normal batteries (NV) and an average value of voltage of the defective batteries (LV), respectively, over time.

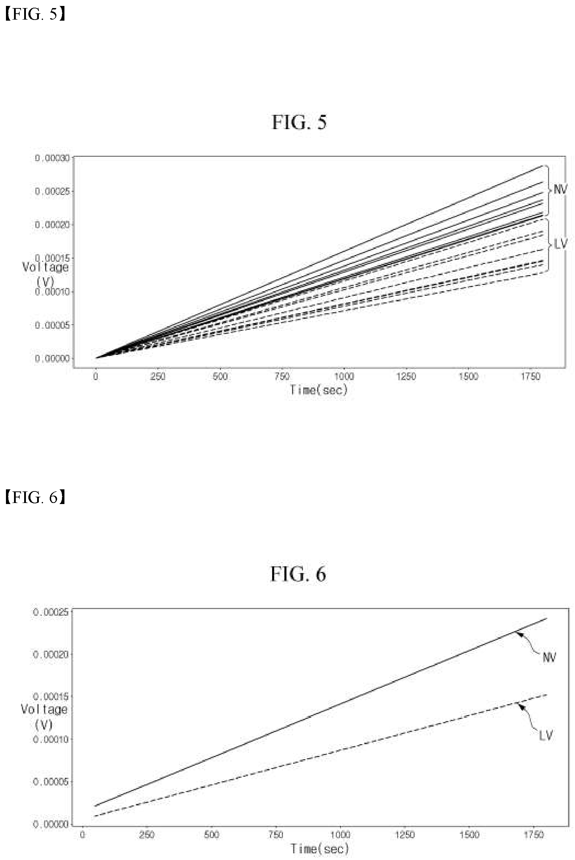

FIG. 5 shows lines connecting the voltage at 0 seconds and the voltage at 1750 seconds of each of the normal batteries (NV), and lines connecting the voltage at 0 seconds and the voltage at 1750 seconds of each of the defective batteries (LV).

FIG. 6 shows a line connecting the average voltage at 0 seconds and the average voltage at 1750 seconds of the normal batteries (NV), and a line connecting the average voltage at 0 seconds and the average voltage at 1750 seconds of the defective batteries (LV).

As shown in FIG. 4 to FIG. 6, when the charging step (S140) is performed under the same conditions, a voltage increase of the defective batteries (LV) during the charging step (S140) may be smaller than a voltage increase of the normal batteries (NV). This may be due to a voltage drop or an internal short circuit caused by metallic foreign matter or the like inside the defective batteries (LV). In the detection step (S150), whether a battery is defective can be determined by comparing a voltage change amount or a slope of voltage over time of the defective batteries (LV) with a voltage change amount or a slope of voltage over time of the normal batteries (NV).

As described above, the present disclosure has been described in more detail through drawings and embodiments. However, it should be understood that the configurations described in the drawings or the embodiments described in the present specification are merely one embodiment of the present disclosure and do not represent all of the technical ideas of the present disclosure, so various equivalents and modifications may exist that can substitute for these at the time of filing the present application.

## Claims

1. A defect inspection method of a secondary battery, comprising:
a first charging step of charging a secondary battery to a first SOC at a first C-rate;
a second charging step of charging the secondary battery to a second SOC at a second C-rate of 0.003 C or less after the first charging step; and
a detection step of determining a defect of the secondary battery after the second charging step,
wherein the second C-rate is smaller than the first C-rate, and wherein the second SOC is greater than the first SOC.

2. The defect inspection method of a secondary battery of claim 1, wherein the second charging step is performed for 5 minutes to 30 minutes.

3. The defect inspection method of a secondary battery of claim 1, wherein the detection step determines whether the secondary battery is defective based on a voltage change amount of the secondary battery during the second charging step.

4. The defect inspection method of a secondary battery of claim 1, wherein the detection step determines whether the secondary battery is defective based on a slope of voltage over time of the secondary battery during the second charging step.

5. The defect inspection method of a secondary battery of claim 1, wherein the detection step determines whether the secondary battery is defective based on voltage change amounts measured for each of a plurality of time intervals during the second charging step.

6. The defect inspection method of a secondary battery of claim 1, comprising, before the first charging step:
a first aging step of aging the secondary battery;
a formation step of charging the secondary battery after the first aging step;
a second aging step of aging the secondary battery after the formation step;
a full charge step of fully charging the secondary battery after the second aging step; and
a full discharge step of fully discharging the secondary battery after the full charge step.

7. The defect inspection method of a secondary battery of claim 1, wherein the second SOC is SOC 30% or less.

8. The defect inspection method of a secondary battery of claim 1, wherein the second C-rate is 4×10⁻¹⁰ C or more.

9. The defect inspection method of a secondary battery of claim 1, wherein the first C-rate is 0.1 C or more and 2.0 C or less.

10. The defect inspection method of a secondary battery of claim 1, wherein each of the first SOC and the second SOC is selected from an SOC section in which a second derivative d²V/dSOC² of voltage-SOC is within a reference range in a voltage-SOC profile during a charging process of a normal battery.

11. The defect inspection method of a secondary battery of claim 10, wherein the voltage-SOC profile of the normal battery comprises a section in which a second derivative d²V/dSOC² of voltage-SOC is 0 between the first SOC and the second SOC.

12. The defect inspection method of a secondary battery of claim 1, wherein each of the first SOC and the second SOC is selected from an SOC section in which a second derivative d²V/dSOC² of voltage-SOC is within a reference range in a voltage-SOC profile during a discharge process of a normal battery.

13. The defect inspection method of a secondary battery of claim 12, wherein the voltage-SOC profile of the normal battery comprises a section in which a second derivative d²V/dSOC² of voltage-SOC is 0 between the first SOC and the second SOC.

14. The defect inspection method of a secondary battery of claim 1, wherein the second SOC is greater than the first SOC by SOC 1% to SOC 5%.

15. The defect inspection method of a secondary battery of claim 1, further comprising a stabilization step of the secondary battery between the first charging step and the second charging step.
